(19) Europäisches Patentamt

European Patent Office

Office européen des brevets

(11) Publication number: **0 114 504**
**B1**

(12) **EUROPEAN PATENT SPECIFICATION**

(45) Date of publication of patent specification: **20.07.88**

(51) Int. Cl.⁴: **G 11 C 17/00**

(21) Application number: **83307826.4**

(22) Date of filing: **21.12.83**

(54) Semiconductor memory device.

(30) Priority: **29.12.82 JP 229267/82**

(43) Date of publication of application:
**01.08.84 Bulletin 84/31**

(45) Publication of the grant of the patent:
**20.07.88 Bulletin 88/29**

(84) Designated Contracting States:
**DE FR GB**

(56) References cited:
**GB-A-2 094 086**

**IBM TECHNICAL DISCLOSURE BULLETIN, vol. 23, no. 10, March 1981, pages 4574-6, New York, US; P.C.TIEN: "Bit line selection circuit for programming level voltages in an electrically alterable read-only storage" IDEM.**

(73) Proprietor: **FUJITSU LIMITED**
**1015, Kamikodanaka Nakahara-ku**
**Kawasaki-shi Kanagawa 211 (JP)**

(72) Inventor: **Arakawa, Hideki**
**Asahi-so, 13-17 Umegaoka Midori-ku**
**Yokohama-shi Kanagawa 227 (JP)**
Inventor: **Kawashima, Hiromi**
**Fujitsu Dai-3 Fujigaoka-ryo 2-1-2 Fujigaoka**
**Midori-ku Yokohama-shi Kanagawa 227 (JP)**

(74) Representative: **George, Sidney Arthur et al**
**GILL JENNINGS & EVERY 53-64 Chancery Lane**
**London WC2A 1HN (GB)**

**Description** -

This invention relates to a semiconductor memory device, and particularly to an electrically erasable non-volatile semiconductor memory device having charge pump circuits for providing a high voltage necessary to write or erase information in the memory device.

An electrically erasable and programmable read-only memory (EEPROM) in general requires a high voltage of 21V to 25V for writing and erasing, in addition to the normal low voltage of 5V. In older designs, since an EEPROM requires a large current and a high voltage for writing and erasing, it is necessary to provide an external high voltage supply besides an external low voltage supply.

Recently, new EEPROM cells with thin dielectrics utilising a tunnelling electron for writing and erasing have been proposed. In such new cells the current required for writing and erasing can be reduced, and d.c. current paths during writing and erasing can be eliminated. As a result, it is possible to put a voltage multiplier on the chip to generate the high voltage required to effect tunnelling and to transfer the high voltage gradually to the selected column and row lines by charge pump circuits, which are connected to each column and row line.

The charge pump circuits are driven by clock pulses from a clock generator. However, in the above prior art construction, since the clock pulses from the clock generator are applied to all of the charge pump circuits and charge a capacitor in each of the charge pump circuits, even though that charge pump circuit is connected to an unselected column or row line, the load on the clock generator becomes extremely heavy.

It is, therefore, an object of the present invention to provide a semiconductor memory device which can greatly reduce the load on a clock pulse generator used for driving charge pump circuits.

According to the present invention, a semiconductor memory device comprising a plurality of column lines; a plurality of row lines; a column decoder connected to the column lines for selecting one of the column lines; a row decoder connected to row lines for selecting one of the row lines; a plurality of memory cells one of which is accessed by a selected column line and a selected row line; a clock generator for producing clock pulses; a voltage supply for supplying a high voltage; and a plurality of charge pump circuits each of which is connected to one of the column lines and the row lines, respectively, and is connected to the clock generator, for increasing the voltage on the selected column and row lines up to the high voltage during writing and/or erasing operations, each of the charge pump circuits including a capacitor for charging and discharging in response to the clock pulses and a charge transfer transistor connected to the capacitor, for transferring charge from the voltage supply to the column or row line connected thereto, in response to the voltage on the capacitor; is characterised in that each charge pump circuit comprises gate means connected between the clock generator and the capacitor, for disconnecting from the clock generator the capacitor in the charge pump circuit connected to an unselected column line or an unselected row line.

Since the capacitors in the charge pump circuits connected to unselected column and row lines are disconnected from the clock generator in the present invention, the load on the clock generator becomes extremely light and thus the dimensions of the clock generator can be reduced. Furthermore, the capacity of a voltage multiplier for producing the high voltage can be reduced.

An embodiment of the invention will now be described, by way of example, with reference to the accompanying drawings, in which:

Fig. 1 is a circuit diagram of an embodiment of the present invention;

Fig. 2 is a circuit diagram of a part of a row decoder of the embodiment shown in Fig. 1;

Fig. 3 is a circuit diagram of a charge pump circuit according to the prior art; and

Fig. 4 is a circuit diagram of a charge pump circuit of the embodiment shown in Fig. 1.

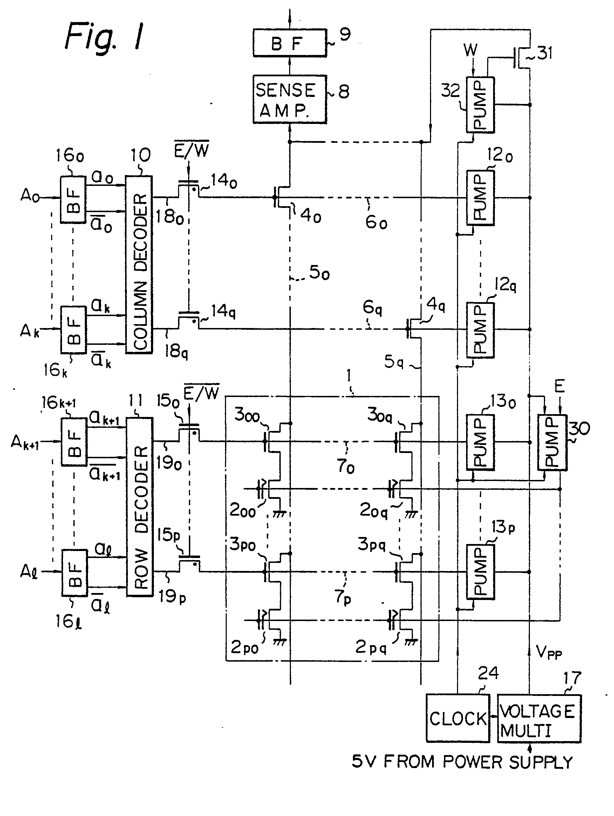

Referring to Fig. 1, an EEPROM utilising a tunnelling electron for writing and erasing comprises a memory cell array 1, memory transistors $2_{00}$ to $2_{pq}$, and select transistors $3_{00}$ to $3_{pq}$. Each one of the memory transistors $2_{00}$ to $2_{pq}$ and each one of the select transistors $3_{00}$ to $3_{pq}$ constitutes a memory cell. The select transistor $3_{00}$ to $3_{pq}$ are connected to bit lines $5_0$ to $5_q$. The bit lines $5_0$ to $5_q$ are connected to a sense amplifier 8 via bit line selection transistors $4_0$ to $4_q$, respectively. The sense amplifier 8 is connected to an output buffer 9. In Fig. 1, a one word-one bit EEPROM is illustrated. If the EEPROM has a one word-eight bits configuration, eight times the memory cell arrays, sense amplifiers, and accompanying lines are necessary. The gates of the bit line selection transistors $4_0$ to $4_q$ are connected to column lines $6_0$ to $6_q$, respectively. One end of each column line $6_0$ to $6_q$ is connected to a column decoder 10 via transfer gates $14_0$ to $14_q$, respectively, made of depletion transistors. The other end of each column line $6_0$ to $6_q$ is connected to a respective charge pump circuit $12_0$ to $12_q$. Gates of the select transistors $3_{00}$ to $3_{pq}$ are connected to row lines $7_0$ to $7_p$. One end of the row lines $7_0$ to $7_p$ are connected to a row decoder 11 via transfer gates $15_0$ to $15_p$ made of depletion transistors having a threshold voltage less than −5V, respectively. The other end of the row lines $7_0$ to $7_p$ are connected to charge pump circuits $13_0$ to $13_p$, respectively. The gates of the memory transistors $2_{00}$ to $2_{pq}$ are connected to a charge pump circuit 30. The bit lines $5_0$ to $5_q$ are also connected to a voltage multiplier 17, for producing a high voltage of 21V to 25V, via a transistor 31 and via the bit line selection transistors $4_0$ to $4_q$.

The gate of the transistor 31 is connected to a charge pump 32. All of the charge pump circuits

$12_0$ to $12_q$, $13_0$ to $13_q$, 30 and 32 are connected to the voltage multiplier 17 and to a clock generator 24. The column decoder 10 and the row decoder 11 are connected to address buffers $16_0$ to $16_k$ and $16_{k+1}$ to $16_l$, respectively.

In a reading mode, for example in the case of reading out information stored in the memory transistor $2_{00}$, addresses $A_0$ to $A_l$ for accessing the memory transistor $2_{00}$ are applied to the column decoder 10 and the row decoder 11 via the address buffers $16_0$ to $16_l$. Thus, the column decoder 10 supplies a voltage of 5V to an output line $18_0$ and grounds output lines $18_1$ to $18_q$. The row decoder 11 supplies a voltage of 5V to an output line $19_0$ and grounds output lines $19_1$ to $19_p$.

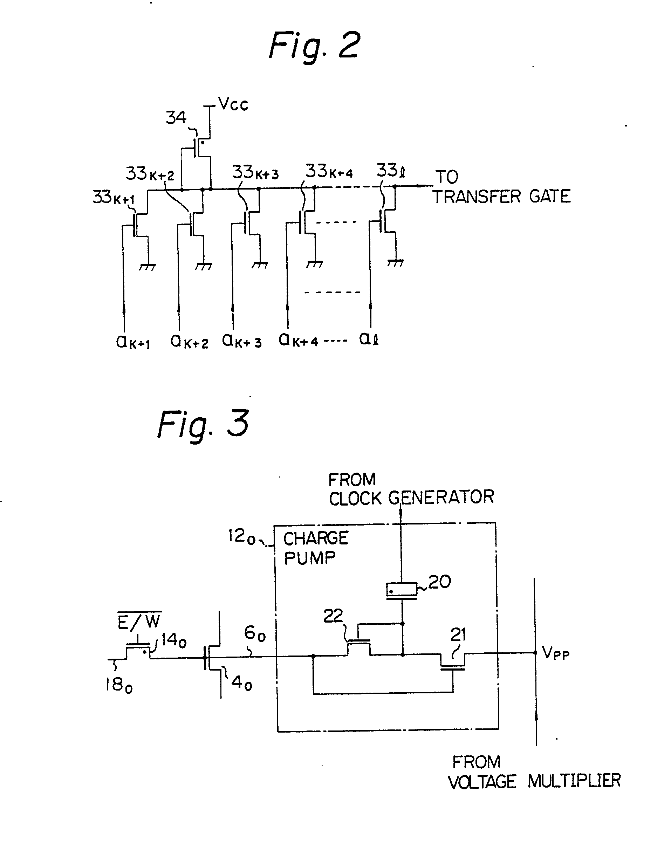

Figure 2 illustrates a part of the row decoder 11 for one row line (one output line). In the above-mentioned case, if the circuit Fig. 2 is for the output line $19_0$, all transistors $33_{k+1}$ to $33_l$ will turn off and a transistor 34 will turn on. Therefore, a $V_{CC}$ voltage of 5V is supplied to the output line $19_0$. If the circuit in Fig. 2 is for one of the output lines $19_1$ to $19_p$, at least one of the transistors $33_{k+1}$ to $33_l$ will turn on, causing the output line to be grounded.

Since all the transfer gates $14_0$ to $14_q$ and $15_0$ to $15_p$ are in the on state during reading, the bit line selection transistor $4_0$ turns on and the select transistor $3_{00}$ is energized when the voltage of 5V is supplied to the output lines $18_0$ and $19_0$. As a result, information stored in the memory transistor $2_{00}$ is detected by the sense amplifier 8.

In the case of erasing or writing, the operation of the colum and row decoders 10 and 11 is the same as that during reading. However, in this case the gate of the depletion transistors which constitute the transfer gates $14_0$ to $14_q$ and $15_0$ to $15_p$ are grounded after the column decoder 10 and the row decoder 11 select one of the column lines and one of the row lines. Furthermore, during erasing and writing, one of the charge pump circuits $12_0$ to $12_q$ connected to the selected column line, and one of the charge pump circuits $13_0$ to $13_p$ connected to the selected row line, operate to increase the voltage on the column and row lines up to the high voltage $V_{pp}$ boosted by the voltage multiplier 17. Namely, the voltage multiplier 17 boosts the supply voltage of 5V to the high voltage $V_{pp}$ of 20V to 25V and the charge pump circuits gradually transfer charge from the voltage multiplier 17 via a high voltage line $V_{pp}$ to the selected column and row lines. As mentioned before, the column and row decoders 10 and 11 supply a voltage of 5V to the selected output lines, for example, to the output lines $18_0$ and $19_0$, and ground the unselected output lines, for example the output lines $18_1$ to $18_q$ and $19_1$ to $19_p$. There-fore, if the gate voltage of the depletion tran-sistors (transfer gates) $14_0$ to $14_q$ and $15_0$ to $15_p$ turn to 0V, the depletion transistors on the selected output lines ($18_0$ and $19_0$) turn off and the depletion transistors on the unselected output lines ($18_1$ to $18_q$ and $19_1$ to $19_p$) do not turn off and are kept in the on state. As a result, the selected column and row lines are kept floating, and the unselected column and row lines are grounded. Therefore, the selected column and row lines $6_0$ and $7_0$ are charged by the charge pump circuits $12_0$ and $13_0$ up to the high voltage of 21V to 25V, but the unselected column and row lines $6_1$ to $6_q$ and $7_1$ to $7_p$ are not charged by the charge pump circuits (kept at 0V).

During writing, furthermore, the charge pump circuit 32 operates to supply high voltage to the gate of the transistor 31 causing the transistor 31 to turn on. Thus, the high voltage $V_{PP}$ from the voltage multiplier 17 can be applied to each of the bit lines. Since the column line $6_0$ is selected, the bit line selection transistor $4_0$ turns on and the high voltage $V_{PP}$ is applied to the bit line $5_0$. Therefore, information is written with respect to the memory transistor $2_{00}$ which corresponds to the selected row line $7_0$ and bit line $5_0$. On the other hand, during erasing, the charge pump circuit 30 operates to charge the gates of all the memory transistors $2_{00}$ to $2_{pq}$ in the memory cell array 1 up to the high voltage $V_{PP}$. Therefore, the information in a memory cell corresponding to the selected column and row lines can be erased.

Figure 3 illustrates a part of Fig. 1, wherein a charge pump circuit according to the prior art is used for the charge pump circuit $12_0$. In Fig. 3, the output line $18_0$, transfer gate $14_0$, bit line selection transistor $4_0$, and column line $6_0$ are the same as these in Fig. 1. The charge pump circuit $12_0$ comprises two transistors 21 and 22 connected in series between the high voltage line $V_{PP}$ and the column line $6_0$, and a metal oxide semiconductor (MOS) capacitor 20. One end of the MOS capacitor 20 is connected to the clock generator 24 (Fig. 1). The other end of the capacitor 20 is connected to the junction of the transistors 21 and 22, and to the gate of the transistor 22. The gate of the transistor 21 is connected to the column line $6_0$.

During writing and erasing, if the column line $6_0$ is selected, since the column line $6_0$ is floating and at 5V, the transistor 21 is on. Thus, the MOS capacitor 20 pumps charge onto the column line $6_0$ through the transistor 22 in response to clock pulses from the clock generator 24 (Fig. 1). Since the column line $6_0$ is floating in this case, the voltage thereof increases up to the high voltage $V_{pp}$ to 21V to 25V, which is supplied from the voltage multiplier 17 (Fig. 1). On the other hand, if the column line $6_0$ is unselected during writing and erasing, since the column line $6_0$ is grounded as described before, the transistor 21 is cut off. Therefore, although clock pulses are applied to the MOS capacitor 20, only a little charge from the high voltage line $V_{pp}$ is transferred to the column line $6_0$. Even if a little charge is transferred to the column line $6_0$, the voltage on the column line $6_0$ will not increase but be kept at 0V, because it is grounded.

However, according to the charge pump circuit shown in Fig. 3, clock pulses are applied to the MOS capacitor 20 even if the column line $6_0$ is unselected. This means that MOS capacitors in all the charge pump circuits $12_0$ to $12_q$ and $13_0$ to $13_p$ are always the load of the clock generator 24. In the case wherein the dimension of the one MOS capacitor 20 W/L=10 μm/10 μm (where W is the channel width and L is the channel length), and there are 256 column lines and 256 row lines in an EEPROM, the total dimension of all the MOS capacitors in the EEPROM becomes very large. Accordingly, the clock generator 24 must be large to deal with the large current.

Furthermore, in the charge pump circuit shown in Fig. 3, little current flows from the high voltage line $V_{pp}$ to an unselected column or row line in response to the clock pulses. Since the number of unselected column and row lines is great, the total current leakage from the high voltage line cannot be ignored. This requires an increased capacity of the voltage multiplier 17.

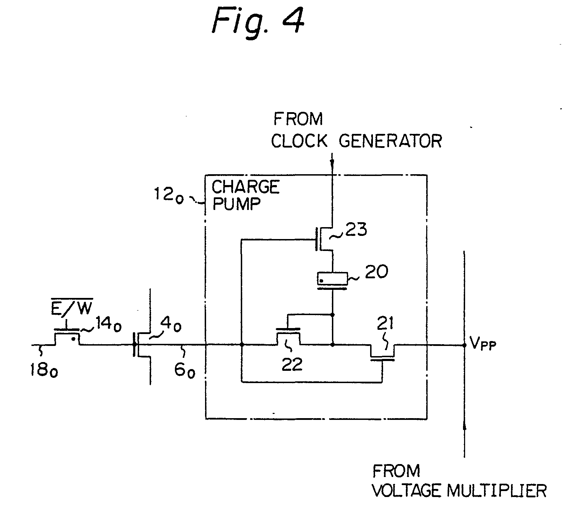

The present invention can solve the above-mentioned problem of the prior art. Figure 4 illustrates a part of Fig. 1, wherein a charge pump circuit forming part of the present invention is used for the charge pump circuit $12_0$. In Fig. 4, the output line $18_0$, transfer gate $14_0$, bit line selection transistor $4_0$, column line $6_0$, MOS capacitor 20, and transistors 21 and 22 are the same as those in Fig. 3. The charge pump circuit in Fig. 4, however, further comprises a transistor 23 connected between the clock generator 24 and the MOS capacitor 20. The gate of the transistor 23 is connected to the column line $6_0$.

During writing and erasing, if the column line $6_0$ is selected, since the column line $6_0$ is floating and at 5V, the transistor 23 is on. Thus, the MOS capacitor 20 is coupled to the clock generator 24 to receive clock pulses and to pump charge onto the column line $6_0$ in response to the clock pulses. On the other hand, if the column line $6_0$ is unselected during writing and erasing, since the column line $6_0$ is grounded, the transistor 23 turns off. Therefore, the MOS capacitor 20 is cut off from the clock generator 24. It will be apparent that, according to the circuit constitution shown in Fig. 4, only charge pump circuits connected to the selected column and row lines become the load on the clock generator 24. The remaining charge pump circuits, which are connected to the unselected column and row lines, do not load the clock generator 24. In fact, the transistor 23 in each of the charge pump circuits connected to the unselected column and row lines will load the clock generator 24 instead of the MOS capacitor 20. However, the dimension of the transistor 23 is small, as W/L=6 μm/3 μm, and thus the capacity of the current required to flow to the clock generator 24 is extremely small (i.e., less than one tenth of the capacity of the current required to flow to the clock generator 24 when the charge pump circuit shown in Fig. 3 is used.

In the aforementioned description, the present invention is applied to an EEPROM. However, the invention is also applicable to an erasable and programmable read only memory (EPROM) if current flowing in cells of the EPROM is small.

## Claims

1. A semiconductor memory device comprising a plurality of column lines ($6_0$ to $6_q$); a plurality of row lines ($7_0$ to $7_p$); a column decoder (10) connected to the column lines ($6_0$ to $6_q$) for selecting one of the column lines ($6_0$ to $6_q$); a row decoder (11) connected to the row lines ($7_0$ to $7_p$) for selecting one of the row lines ($7_0$ to $7_p$); a plurality of memory cells ($2_{00}$ to $2_{pq}$, $3_{00}$ to $3_{pq}$) one of which is accessed by means of a selected column line and a selected row line; a clock generator (24) for producing clock pulses; a voltage supply (17) for supplying a high voltage; and a plurality of charge pump circuits ($12_0$ to $12_q$, $13_0$ to $13_p$) each of which is connected to one of the column lines ($6_0$ to $6_q$) and the row lines ($7_q$ to $7_p$), respectively, and is connected to the clock generator (24), for increasing the voltage on the selected column and row lines up to the high voltage during writing and/or erasing operations, each of the charge pump circuits ($12_0$ to $12_q$, $13_0$ to $13_p$) including a capacitor (20) for charging and discharging in response to the clock pulses, and a charge transfer transistor (22) connected to the capacitor (20), for transferring charge from the voltage supply (17) to the column or row line connected thereto, in response to the voltage on the capacitor (20); characterised in that each charge pump circuit ($12_0$ to $12_q$, $13_0$ to $13_p$ comprises gate means connected between the clock generator (24) and the capacitor (20), for disconnecting from the clock generator the capacitor (20) in the charge pump circuit connected to an unselected column line or an unselected row line.

2. A device as claimed in Claim 1, characterised in that the gate means includes a transistor (23) connected between the clock generator (24) and the capacitor (20), the transistor (23) being on when the column or row line connected to the charge pump circuit of the gate means is selected and being off when the column or row line connected to the charge pump circuit of the gate means is unselected.

3. A device as claimed in Claim 2, characterised in that the transistor (23) in each charge pump circuit has a gate electrode connected to the column or row line which is connected to the charge pump circuit of the transistor (23).

4. A device as claimed in any preceding claim, characterised in that the column and row decoders (10, 11) supply a source voltage to the selected column and row lines and ground the unselected column and row lines.

5. A device as claimed in any preceding claim, characterised by a plurality of transistors ($14_0$ to $14_q$, $15_0$ to $15_p$) connected between the column decoder (10) and the column lines ($6_0$ to $6_q$) and between the row decoder (11) and the row lines ($7_0$ to $7_p$), said transistors being off only when the column line and the row line connected thereto are selected during writing and erasing operations to disconnect the selected column and row lines from the column and row decoders (10, 11), respectively.

6. A device as claimed in any preceding claim, characterised in that each of the memory cells ($2_{00}$ to $2_{pq}$, $3_{00}$ to $3_{pq}$) includes a selection transistor used for selection of the memory cells, and a memory transistor connected to the selection transistor for storing information.

**Patentansprüche**

1. Halbleiterspeichervorrichtung mit einer Vielzahl von Spaltenleitungen ($6_0$ bis $6_q$); einer Vielzahl von Reihenleitungen ($7_0$ bis $7_p$); einem Spaltendecoder (10), der mit den Spaltenleitungen ($6_0$ bis $6_q$) verbunden ist, zum Auswählen einer der Spaltenleitungen ($6_0$ bis $6_q$); einem Reihendecoder (11), der mit den Reihenleitungen ($7_0$ bis $7_p$) verbunden ist, um eine der Reihenleitungen ($7_0$ bis $7_p$) auszuwählen; einer Vielzahl von Speicherzellen ($2_{00}$ bis $2_{pq}$, $3_{00}$ bis $3_{pq}$), von denen zu einer mittels einer ausgewählten Spaltenleitung und einer ausgewählten Reihenleitung zugegriffen wird; einem Taktgenerator (24) zum Erzeugen von Taktimpulsen; einer Spannungsversorgung (17) zum Zuführen einer hohen Spannung; und einer Vielzahl von Ladungspumpenschaltungen ($12_0$ bis $12_q$, $13_0$ bis $13_p$) von denen jede mit einer der Spaltenleitung ($6_0$ bis $6_q$) bzw. der Reihenleitung ($7_0$ bis $7_p$) verbunden ist, und mit dem Taktgenerator (24) verbunden ist, um, während der Schreib- und/oder Löschoperationen, die Spannung der ausgewählten Spalten- und Reihenleitungen zu erhöhen, bis zu der hohen Spannung, jede der Ladungspumpenschaltungen ($12_0$ bis $12_q$, $13_0$ bis $13_p$) einen Kondensator (20) umfaßt, um in Abhängigkeit von den Taktimpulsen aufzuladen oder zu entladen, und einen Ladungstransfertransistor (22), der mit dem Kondensator (20) verbunden ist, um die Ladung von der Spannungsversorgung (17) zu der Spalten- oder Reihenleitung, die mit dieser verbunden ist, in Abhängigkeit von der Spannung des Kondensators (20), zu übertragen, dadurch gekennzeichnet, daß jede Ladungspumpenschaltung ($12_0$ bis $12_q$, $13_0$ bis $13_p$) Torschaltungseinrichtungen umfaßt, die zwischen dem Taktgenerator (24) und dem Kondensator (20) angeschlossen sind, um den Kondensator (20) in der Ladungspumpenschaltung, die mit einer nicht ausgewählten Spaltenleitung oder einer nicht ausgewählten Reihenleitung verbunden ist, von dem Taktgenerator (24) zu trennen.

2. Vorrichtung nach Anspruch 1, dadurch gekennzeichnet, daß die Torschaltungseinrichtung einen Transistor (23) umfaßt, der zwischen dem Taktgenerator (24) und dem Kondensator (20) angeschlossen ist, welcher Transistor (23) ein ist, wenn die Spalten- oder Reihenleitung, die mit der Ladungspumpenschaltung der Torschaltungeinsrichtung verbunden ist, ausgewählt ist, und der aus ist, wenn die Spalten- oder Reihenleitung, die mit der Ladungspumpenschaltung der Torschaltungseinrichtung verbunden ist, nicht ausgewählt ist.

3. Vorrichtung nach Anspruch 2, dadurch gekennzeichnet, daß der Transistor (23) in jeder Ladungspumpenschaltung eine Gateelektrode hat, die mit der Spalten- oder Reihenleitung verbunden ist, welche mit der Ladungspumpenschaltung des Transistors (23) verbunden ist.

4. Vorrichtung nach einem der vorhergehenden Ansprüche, dadurch gekennzeichnet, daß die Spalten- und Reihendecoder (10, 11) eine Quellenspannung zu den ausgewählten Spalten- und Reihenleitungen liefern, und die nicht ausgewählten Spalten- und Reihenleitungen erden.

5. Vorrichtung nach einem der vorhergehenden Ansprüche, gekennzeichnet durch eine Vielzahl von Transistoren ($14_0$ bis $14_q$, $15_0$ bis $15_p$), die zwischen dem Spaltendecoder (10) und den Spaltenleitungen ($6_0$ bis $6_q$) und zwischen dem Reihendecoder (11) und den Reihenleitungen ($7_0$ bis $7_p$) angeschlossen sind, welche Transistoren nur aus sind, wenn die Spaltenleitung und die Reihenleitung, die damit verbunden sind, während der Schreib- und Löschoperationen ausgewählt werden, um die ausgewählten Spalten- und Reihenleitungen von den Spalten- bzw. Reihendecodern (10, 11) zu trennen.

6. Vorrichtung nach einem der vorhergehenden Ansprüche, dadurch gekennzeichnet, daß jede der Speicherzellen ($2_{00}$ bis $2_{pq}$, $3_{00}$ bis $3_{pq}$) einen Auswahltransistor umfaßt, der zur Auswahl der Speicherzellen verwendet wird, und einen Speichertransistor, der mit dem ausgewählten Transistor zur Speicherung der Information verbunden ist.

**Revendications**

1. Dispositif de mémoire à semiconducteur comprenant un ensemble de fils de colonne ($6_0$ à $6_q$); un ensemble de fils de lignes ($7_0$ à $7_p$); un décodeur de colonne (10) connecté aux fils de colonne ($6_0$ à $6_q$) pour sélectionner un des fils de colonne ($6_0$ à $6_q$); un décodeur de ligne (11) connecté aux fils de ligne ($7_0$ à $7_9$) pour sélectionner un des fils de ligne ($7_0$ à $7_p$); un ensemble de cellules de mémoire ($2_{00}$ à $2_{pq}$, $3_{00}$ à $3_{pq}$) dont chacune fait l'objet d'un accès au moyen d'un fil de colonne sélectionné et d'un fil de ligne sélectionné; un générateur d'impulsions d'horloge (24) pour produire des impulsions d'horloge; une source de tension (17) pour fournir une tension élevée; et un ensemble de circuits à pompage de charges ($12_0$ à $12_q$, $13_0$ à $13_p$) dont chacun est connecté à un des fils de colonne ($6_0$ à $6_q$) et des fils de ligne ($7_0$ à $7_p$), respectivement, et connecté au générateur d'impulsions d'horloge (24), pour augmenter la tension sur les fils de colonne et de ligne sélectionnés jusqu'à la tension élevée pendant des opérations d'écriture et/ou d'effacement, chacun des circuits à pompage de charges ($12_0$ à $12_q$, $13_0$ à $13_p$) incluant un condensateur (20) pour une charge et une décharge en réponse aux impulsions d'horloge, et un transistor de transfert de charges (22) connecté au condensateur (20), pour transférer des charges de la source de tension (17) jusqu'au fil de colonne ou de ligne qui lui est connecté, en réponse à la tension sur le condensateur (20); caractérisé en ce que chaque circuit à pompage de charges ($12_0$ à $12_q$, $13_0$ à $13_p$)

comprend un moyen à porte connecté entre le générateur d'impulsions d'horloge (24) et le condensateur (20), pour déconnecter du générateur d'impulsions d'horloge le condensateur (20) contenu dans le circuit à pompage de charges connecté à un fil de colonne non sélectionné ou à un fil de ligne non sélectionné.

2. Dispositif selon la revendication 1, caractérisé en ce que le moyen à porte comprend un transistor (23) connectée entre le générateur d'impulsions d'horloge (24) et le condensateur (20), le transistor (23) étant conducteur quand le fil de colonne ou de ligne connecté au circuit à pompage de charges du moyen à porte est sélectionné et étant bloqué quand le fil de colonne ou de ligne connecté au circuit à pompage de charges du moyen à porte est non sélectionné.

3. Dispositif selon la revendication 2, caractérisé en ce que le transistor (23) contenue dans chaque circuit à pompage de charges a une électrode de grille connectée au fil de colonne ou de ligne qui est connecté au circuit à pompage de charges du transistor (23).

4. Dispositif selon l'une quelconque des revendications 1 à 3, caractérisé en ce que les décodeurs de colonne et de ligne (10, 11) fournissent une tension de source aux fils de colonne et de ligne sélectionnés et mettent à la masse les fils de colonne et de ligne non sélectionnés.

5. Dispositif selon l'une quelconque des revendications 1 à 4, caractérisé par un ensemble de transistors ($14_0$ à $14_q$, $15_0$ à $15_p$) connectés entre le décodeur de colonne (10) et les fils de colonne ($6_0$ à $6_q$) et entre le décodeur de ligne (11) et les fils de lignes ($7_0$ à $7_p$), les transistors n'étant bloqués que lorsque le fil de colonne et le fil de ligne qui leurs sont connectés sont sélectionnés pendant des opérations d'écriture et d'efficacement pour déconnecter les fils de colonne et de ligne sélectionnés respectivement des décodeurs de colonne et de ligne (10, 11).

6. Dispositif selon l'une quelconque des revendications 1 à 5, caractérisé en ce que chacune des cellules de mémoire ($2_{00}$ à $2_{pq}$, $3_{00}$ à $3_{pq}$) comprend un transistor de sélection utilisé pour la sélection des cellules de mémoire, et un transistor de mémoire connecté au transistor de sélection pour mémoriser une information.

Fig. 1

5V FROM POWER SUPPLY

# Fig. 2

# Fig. 3

# Fig. 4

FROM
CLOCK GENERATOR

CHARGE
$12_0$ PUMP

~23

~20

$\overline{E/W}$ ~$14_0$ $4_0$

21

$18_0$ $6_0$ 22 $V_{PP}$

FROM
VOLTAGE MULTIPLIER